Europäisches Patentamt

European Patent Office

Office européen des brevets

(19)

(11) Publication number:

**0 396 954**

**A1**

# EUROPEAN PATENT APPLICATION

(21) Application number: 90107668.7

(22) Date of filing: 23.04.90

(51) Int. Cl.⁵: **H05K 1/03, H05K 3/42,**
    **H05K 1/00**

(30) Priority: **11.05.89 JP 116132/89**

(43) Date of publication of application:
    **14.11.90 Bulletin 90/46**

(84) Designated Contracting States:
    **DE FR GB**

(71) Applicant: **JAPAN GORE-TEX, INC.**
    **42-5, 2-chome Akazutsumi**
    **Setagaya-ku Tokyo 156(JP)**

(72) Inventor: **Hatakeyama, Minoru**
    **1-22, 7-chome, Sakuragaokanishi, Sanyo-cho**
    **Akaiwa-gun, Okayama-ken 709, 08(JP)**
    Inventor: **Nomi, Haruo**
    **15-9, 1-chome, Sakuragaokanishi, Sanyo-cho**
    **Akaiwa-gun, Okayama-ken 709, 08(JP)**

(74) Representative: **Klunker . Schmitt-Nilson .**
    **Hirsch**
    **Winzererstrasse 106**
    **D-8000 München 40(DE)**

(54) **A printed circuit board.**

(57) A multilayer printed circuit board is provided wherein the printed circuit board having through-hole metal plating (13) contains at least one cushioning layer (12). The cushioning layer (12) effectively protects the board against cracks in the through-hole plating (13). The cushioning layer (12) is a layer of porous plastic, preferably expanded, porous polytetrafluoroethylene (PTFE).

_Fig.1._

## BACKGROUND OF THE INVENTION

The present invention relates to a printed circuit board. More specifically, the present invention concerns a means of improving the thermal shock resistance of the through-hole metal plating of a printed circuit board.

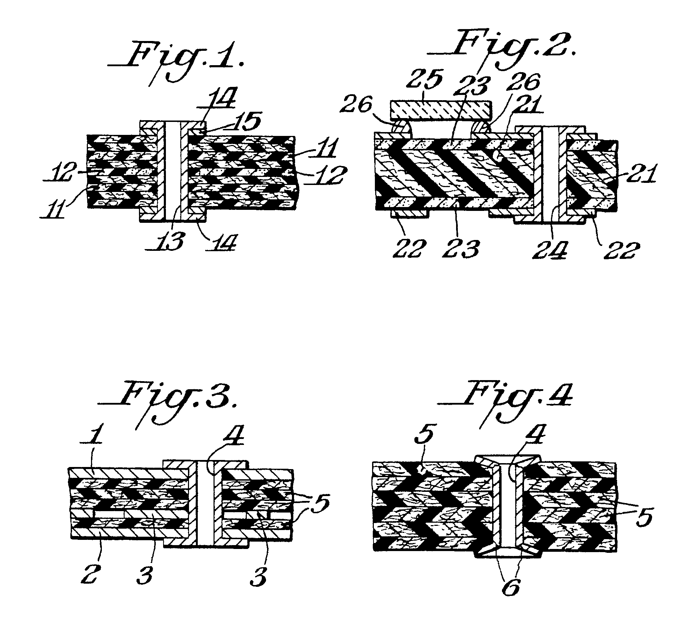

In printed circuit boards having copper installed on both sides and multilayer circuit boards, through-hole plating is installed in order to provide electrical connections between the layers of the copper circuits. Fig. 3 shows a cross-section of one example of such a conventional circuit board. In this circuit board, circuits or wiring layers 1 and 2, formed by etching a copper foil, are present on both surfaces and in an internal layer 3 of a multilayer board manufactured by laminating a number of prepreg layers together. Electrical connections between these wiring layers are obtained by plating through-holes, which pass through the multilayer board, with a copper plating 4.

Through-hole plating formed in a printed circuit board is ordinarily formed so that it extends from the through-hole wall surfaces onto and overlapping the board surfaces as shown in Fig. 3. This is done in order to insure that a good electrical connection is obtained between (a) the through-hole plating 4 and (b) the circuits 1 and 2 on the board surfaces and the internal layer circuits 3.

In such a structure, however, there is a large difference in coefficient of thermal expansion between the copper of the through-hole plating 4 and layers 5 of the multilayer board, which is formed by laminating prepreg layers consisting of a glass cloth impregnated with a resin such as an epoxy. Accordingly, when a thermal shock is applied to the printed circuit board, the phenomenon of barrel cracking is seen, in which the through-hole plating 4 is stretched into the form of a barrel so that cracks 6 appear as shown in Fig. 4. The appearance of cracks in the through-hole plating can lead to faulty electrical connections or even disconnection and wire breakage.

Accordingly, an object of the present invention is to improve the thermal shock resistance of printed circuit boards which have such through-hole plating.

## SUMMARY OF THE INVENTION

A multilayer printed circuit board is provided comprising a printed circuit board having through-hole metal plating and containing at least one cushioning layer of a porous plastic, preferably expanded, porous polytetrafluoroethylene.

## BRIEF DESCRIPTION OF THE DRAWINGS

Fig. 1 is a cross-sectional view showing one embodiment of a printed circuit board according to the invention.

Fig. 2 shows, in cross-section, a second embodiment of a printed circuit board according to the invention.

Fig. 3 is a cross-section of a conventional printed circuit board.

Fig. 4 is a cross-sectional view illustrating cracks which may occur in the through-hole plating of a conventional printed circuit board.

## DETAILED DESCRIPTION OF THE INVENTION AND PREFERRED EMBODIMENTS WITH REFERENCE TO THE DRAWINGS

A multilayer printed circuit board is provided wherein the printed circuit board having through-hole metal plating contains at least one cushioning layer. The cushioning layer effectively protects the board against cracks in the through-hole plating. The cushioning layer is a layer of porous plastic, preferably expanded, porous polytetrafluoroethylene (PTFE).

More specifically, the present invention provides a printed circuit board which is characterized by the fact that at least one layer in the multilayer board having through-hole plating is a cushioning layer.

A porous resin is preferred for use as the cushioning layer, and expanded, porous polytetrafluoroethylene is most preferred.

Expanded, porous polytetrafluoroethylene (PTFE) is a highly flexible material. A process for its manufacture is disclosed in U.S. Patent 3,953,566. Accordingly, by installing at least one layer of such a material in the aforementioned multilayer board, it is possible to relax the thermal stress applied to the through-hole plating under thermal shocks so that the generation of cracks can be substantially prevented. For purposes of such stress relaxation, it is desirable that the expanded, porous PTFE be laminated "as is" without impregnating the pores of the PTFE with a resin. However, it is also effective to install a thin adhesive layer on the surface of the expanded, porous PTFE and thus use the PTFE as a prepreg, or to use the PTFE as a prepreg in which an adhesive layer is formed by impregnating the pores of the PTFE with a resin. The reason for this is that expanded, porous PTFE has low elasticity compared to a glass cloth even when the interior of the PTFE is filled with a resin. Accordingly, the flexibility obtained is superior to that obtained using only a prepreg formed by impregnating a glass cloth with a resin.

There are no particular restrictions on the number of layers of expanded, porous PTFE used, the positions of the layers, or the thicknesses of the layers.

Fig. 1 illustrates one embodiment of the present invention. In this embodiment, an expanded, porous PTFE layer 12 is used as roughly the center layer in an ordinary multilayer board having glass-epoxy layers 11. Generally, barrel cracks tend to be generated most readily in the vicinity of this position. Accordingly, it is desirable to install an expanded, porous PTFE layer in this position, i.e., in the vicinity of the center of the multilayer board, to act as a stress relaxation layer. For example, in the abovementioned multilayer board, prepreg layers formed by impregnating a glass cloth with an epoxy resin so that B-stage layers are obtained are installed between glass-epoxy core materials on which circuits are formed by etching. However, in the central portion of the multilayer board, a material formed as a prepreg by coating both surfaces of an expanded, porous PTFE layer having thickness about 100 microns, porosity about 80% and mean pore diameter about 2.5 microns with an epoxy resin to respective thicknesses of 20 microns on both sides is installed instead of the abovementioned epoxy prepreg. The board is then laminated by compression under heating. The thickness of the laminated product is about 4.8 mm. Through-holes with a diameter of 0.35 mm are formed in this laminated product, and the through-holes are then plated with copper to a thickness of about 25 microns. This through-hole plating 13 is formed so that it extends over copper foil land parts 15 with an external diameter of about 0.7 mm which are located around the circumference of the through-holes on both sides of the laminated board. When such a laminated board equipped with through-hole plating was subjected to 100 thermal stress cycles, no cracks were generated in the through-hole plating. In contrast, when a similar multilayer board from which the aforementioned expanded, porous PTFE layer was omitted was subjected to the same thermal stress cycles, barrel cracks appeared in the 56th cycle, and these barrel cracks ultimately led to wire breakage.

Fig. 2 illustrates another desirable configuration of the present invention. In this example, respective expanded, porous PTFE layers 23 are formed directly beneath copper circuit layers 22 which are installed on both surfaces of a substrate 21. Thermal stress acting on the through-hole plating 24 can also be relaxed by using expanded, porous PTFE layers in these positions. Another important advantage obtained by the installation of expanded, porous PTFE layers beneath the copper circuits on both surfaces of the substrate as described above is that the expanded, porous PTFE acts to prevent damage to electrical connectors such as solder 26 between chips 25 and the substrate 21 caused by differences in the coefficient of thermal expansion between the chips 25 and substrate 21 in the case of surface mounting of chips, which has become popular in recent years. This effect of the use of expanded, porous PTFE in the surface mounting of chips can also be obtained in cases where there are no through-holes, i.e., in cases where a copper circuit layer is formed on only one side of the substrate and chips are mounted on the copper circuit layer, by installing an expanded, porous PTFE layer underneath the copper circuit layer.

As a result of the present invention, damage to through-hole plating or chip mountings in printed circuit boards caused by thermal stress arising from differences in coefficient of thermal expansion between the substrate of the printed circuit board and the through-hole plating or chip mountings can be effectively prevented by including expanded, porous PTFE layers in the substrate of the circuit board.

While the invention has been disclosed herein in connection with certain embodiments and detailed descriptions, it will be clear to one skilled in the art that modifications or variations of such details can be made without deviating from the gist of this invention, and such modifications or variations are considered to be within the scope of the claims hereinbelow.

## Claims

1. A multilayer printed circuit board comprising a printed circuit board having through-hole metal plating and containing at least one cushioning layer of a porous plastic.

2. The printed circuit board of claim 1 wherein said cushioning layer is expanded, porous polytetrafluoroethylene.

*Fig.1.*

*Fig.2.*

*Fig.3.*

*Fig.4*

European Patent
Office

**EUROPEAN SEARCH REPORT**

Application Number

EP 90 10 7668

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 299 595 (JUNKOSHA CO., LTD)<br>* Column 2, line 36 - column 3, line 4 * | 1-2 | H 05 K 1/03<br>H 05 K 3/42<br>H 05 K 1/00 |
| A | FR-A-2 525 849 (HUTCHINSON) | | |
| A | IBM TECHNICAL DISCLOSURE BULLETIN, vol. 15. no. 5, October 1972, page 1496, New York, US; R.N. WILD: "Crack-resistant plated through-holes for multilayer interconnection boards" | | |
| A | GB-A-2 047 974 (KOLLMORGEN TECHNOLOGIES CORP.) | | |

TECHNICAL FIELDS
SEARCHED (Int. Cl.5)

H 05 K

The present search report has been drawn up for all claims

| Place of search | Date of completion of the search | Examiner |
|---|---|---|
| THE HAGUE | 17-08-1990 | SCHUERMANS N.F.G. |

EPO FORM 1503 03.82 (P0401)